# EUROPÄISCHE PATENTSCHRIFT

(11) **EP 1 191 352 B1**
(45) Veröffentlichungstag und Bekanntmachung des Hinweises auf die Patenterteilung: **04.03.2009**
(21) Anmeldenummer: 01120122.5
(22) Anmeldetag: 22.08.2001
(51) Int. Cl.: G01V 8/10

(54) **Lichtschrankenanordnung mit Schnittstelle**
Interface for optical barrier
Interface pour barrière optique

(30) Priorität: 20.09.2000 DE 10046863
(43) Veröffentlichungstag der Anmeldung: 27.03.2002
(73) Patentinhaber: Leuze lumiflex GmbH + Co. KG, 82256 Fürstenfeldbruck (DE)
(72) Erfinder: Hartl, Paul, 80797 München (DE)
(74) Vertreter: Ruckh, Rainer Gerhard

(56) Entgegenhaltungen:
- EP-A- 0 813 128
- DE-A- 4 216 242
- US-A- 5 261 015

## Beschreibung

Die Erfindung betrifft eine Lichtschrankenanordnung gemäß dem Oberbegriff des Anspruchs 1.

Die DE 42 16 242 A1 zeigt einen Schnittstellenbaustein für Sensoren, z.B. Lichtschranken, der zur Ankopplung der Sensoren eine Daten- und eine Parameterschnittstelle aufweist. In einem Konfigurationsbetrieb, der durch das Schalten eines magnetischen Schalters eingeleitet wird, werden Daten zwischen einer Steuereinheit und den Sensoren über die Parameterschnittstelle ausgetauscht.

Die EP 0 813 128 A2 beschreibt einen Mehrfachsensor zum Anschluss an ein BUS-System, insbesondere ein AS-Interface, mit einem Gehäuse, das eine Slave-Anschaltung und eine elektrische Schnittstelle aufweist. An die Schnittsetlle sind Sensorköpfe angeschlossen, wobei die elektrische Schnittstelle ausschließlich an die angeschlossenen Sensorköpfe angepasst ist.

Die US 5,261,015 betrifft einen monolithisch gefertigten, magnetisch betätigbaren opto-mechanischen Ein-/Aus-Schalter.

Unter dem Begriff "Lichtschrankenanordnung" sind optoelektronische Sensoren zur Überwachung eines Gefahrenbereiches zu verstehen, wie z.B. einzelne Lichtschranken, Lichtgitter, Lichtvorhänge etc. Derartige Lichtschrankenanordnungen weisen eine Steuerelektronik auf, die vor Inbetriebnahme den Anwendungsbedingungen entsprechend konfiguriert, d.h. programmiert werden muß oder zu Diagnosezwecken ausgelesen werden muß. Herkömmliche Lichtschrankenanordnungen weisen hierfür eine Schnittstelle mit einer aufschraubbaren Öffnung auf, in die man einen Diagnosestecker einführen kann. Das Aufschrauben der Anschlußöffnung ist umständlich und zeitaufwendig und kann zu Dichtungsproblemen oder zum Verlust einzelner Teile, wie z.8. Schrauben etc., führen. Durch das Anklemmen oder Anstecken der Diagnoseschnittstelle ist eine Dejustage der Lichtschrankenanordnung nicht ausgeschlossen. Dies ist problematisch gerade dann, wenn das Diagnosehilfsmittel als Kontrolle der Justage benützt werden soll.

Der Erfindung liegt die Aufgabe zugrunde, ein für eine Lichtschrankenanordnung eine verbesserte Schnittstelle bereitzustellen, die bei einfachem Aufbau leicht handhabbar ist und problemlos einen hohen Schutzgrad gegen Schmutz und Feuchtigkeit einhält.

Diese Aufgabe wird durch die Merkmale des Patentanspruches 1 gelöst. Vorteilhafte Ausgestaltungen und Weiterbildungen der Erfindung sind den Unteransprüchen zu entnehmen.

Grundprinzip der Erfindung ist ein optoelektronischer Datenaustausch, der durch einen magnetisch betätigbaren Schalter aktivierbar ist.

An der Lichtschrankenanordnung ist eine Schnittstellenkomponente vorgesehen, die eine erste optoelektronische Kommunikationseinrichtung und den magnetisch betätigbaren Schalter aufweist. Der magnetisch betätigbare Schalter kann im einfachsten Fall ein "Reed-Kontakt" sein. Es sind aber auch elektronische magnetische Komponenten denkbar, wie z.8. Feldplatten, Hall-Generatoren oder elektronische Magnetsensoren in Form von integrierten Schaltungen. Die erste Kommunikationseinrichtung und der magnetisch betätigbare Schalter wirken mit einem externen, an die Schnittstellenkomponente der Lichtschrankenanordnung "ansteckbaren" bzw. "ansetzbaren" Schnittstellenelement zusammen, das eine zugeordnete zweite optoelektronische Kommunikationseinrichtung sowie einen Magneten zur Betätigung des Schalters aufweist. Die erste Kommunikationseinrichtung weist ein Lichtsendeelement und ein Lichtempfangselement auf, die eine Infrarotkopplung zwischen dem externen Schnittstellenelement und der Lichtschrankenanordnung ermöglichen. Das externe Schnittstellenelement hat als Kommunikationseinrichtung entweder ein Paar von Lichtsende- und Lichtempfangselementen oder eine Lichtleiteinrichtung, wie z.B. eine Lichtleitfaser, ein Prisma oder eine Spiegelanordnung, die von der ersten Kommunikationseinrichtung abgestrahltes Licht zu deren Lichtempfangselement zurückleitet.

Nach einer Weiterbildung der Erfindung weist das externe Schnittstellenelement einen Anschluß bzw. ein Kabel zur Verbindung mit einem Konfigurierungs-/Diagnosegerät, wie z.B. einem PC, auf.

Für bestimmte Betriebsarten hat das externe Schnittstellenelement einen "durchgeschleiften" Lichtleiter, der das Lichtsendeelement und das Lichtempfangselement des externen Schnittstellenelements optisch miteinander verbindet. Mit diesem Schnittstellenelement kann also die erste Kommunikationseinrichtung "optisch kurzgeschlossen" werden, d.h. das Lichtsendeelement der Schnittstellenkomponente kann über das externe Schnittstellenelement optisch mit dem Lichtempfangselement der Schnittstellenkomponente verbunden werden.

Das Lichtsende- und das Lichtempfangselement sowie der magnetisch betätigbare Schalter sind hinter einer lichtdurchlässigen und magnetisch permeablen Abdeckplatte angeordnet. Der Magnet ist vorzugsweise so stark, daß das externe Schnittstellenelement ggf. einschließlich des Kabels allein durch die Magnetkräfte auch an einer senkrecht stehenden Abdeckplatte der Lichtschrankenanordnung fixierbar ist.

Nach einer Weiterbildung der Erfindung sind das externe Schnittstellenelement bzw. die Lichtschrankenanordnung so ausgebildet, daß sich beim "Ansetzen" des externen Schnittstellenelementes an die Lichtschrankenanordnung die ersten und zweiten Lichtsende- bzw. Lichtempfangselemente allein durch die Magnetkräfte aneinander ausrichten, so daß eine einwandfreie Datenübertragung sichergestellt ist. Mit anderen Worten wird der Schalter nur dann betätigt, wenn die optischen Elemente korrekt zueinander ausgerichtet sind.

Nach einer Weiterbildung der Erfindung sind das Lichtsende-, das Lichtempfangselement sowie der magnetisch betätigbare Schalter an eine Steuerelektronik angeschlossen, wobei dem Lichtsendeelement und dem Lichtempfangselement jeweils ein separater Controller zugeordnet sein kann.

Mit der Erfindung ist somit eine einfache Plazierung des externen Schnittstellenelementes an der Lichtschrankenanordnung und ein zuverlässiger Datenaustausch über eine InfrarotKopplung möglich, wobei durch den in das externe Schnittstellenelement integrierten Magneten eine automatische Betätigung des Schalters und damit eine Aktivierung der Schnittstelle für eine Umschaltung in den Konfigurations- oder Diagnosemodus erfolgt.

Im folgenden wird die Erfindung anhand von Ausführungsbeispielen im Zusammenhang mit der Zeichnung näher erläutert.
Es zeigen:
- Fig. 1: ein erstes Ausführungsbeispiel der Erfindung für eine erste Betriebsart; und
- Fig. 2: ein zweites Ausführungsbeispiel der Erfindung für eine zweite Betriebsart.

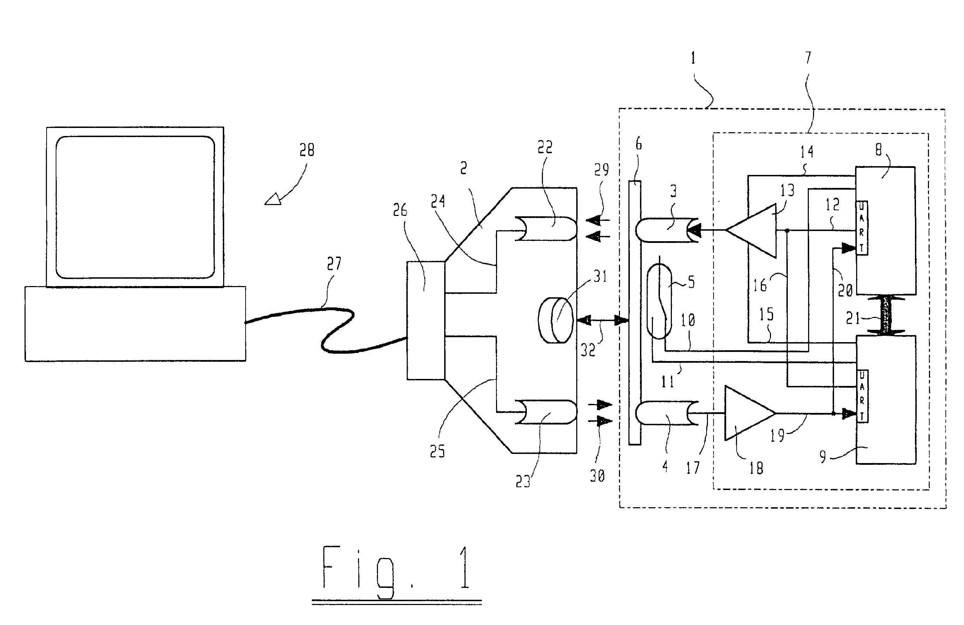

Fig. 1 zeigt eine Schnittstelle für Lichtschrankenanordnungen mit einer ersten Schnittstellenkomponente 1 und einem damit koppelbaren externen Schnittstellenelement 2. Die erste Schnittstellenkomponente 1 kann integraler Bestandteil einer Lichtschrankenanordnung sein, die eine Vielzahl von Lichtsendeelementen bzw. Lichtempfangselementen (nicht dargestellt) aufweisen kann.

Die erste Schnittstellenkomponente 1 weist ein erstes Lichtsendeelement 3, ein erstes Lichtempfangselement 4 und einen magnetisch betätigbaren Schalter 5 auf, die hinter einer lichtdurchlässigen Abdeckplatte 6 angeordnet sind. Das erste Lichtsendeelement 3, das erste Lichtempfangselement 4 und der magnetisch betätigbare Schalter 5, der z.B. ein "Reed-Schalter" ist, sind an eine Mikroprozessorsteuerung 7 angeschlossen. Die Mikroprozessorsteuerung 7 weist einen ersten Controller 8 und einen zweiten Controller 9 auf, die jeweils über zugeordnete Steuerleitungen 10, 11 mit dem magnetisch betätigbaren Schalter 5 verbunden sind. Der erste Controller 8 ist ferner über eine Leitung 12 und einen Verstärker 13 mit dem Lichtsendeelement 3 verbunden. Der Verstärker 13 ist über Versorgungsleitungen 14, 15 mit den Controllern 8 bzw. 9 verbunden. Ferner führt eine Leitung 16 vom Eingang des Verstärkers 13, d.h. von der Leitung 12 zum Controller 9.

Das Lichtempfangselement 4 ist über eine Leitung 17 und einen Verstärker 18 und einen Verstärkerausgang 19 mit dem Controller 9 verbunden. Ferner führt eine Leitung 20 vom Verstärkerausgang 19 zum Controller 8. Der zwischen den beiden Controllern stattfindende Datenaustausch ist schematisch durch den Pfeil 21 dargestellt.

Das externe Schnittstellenelement 2 weist ein zweites Lichtempfangselement 22 und ein zweites Lichtsendeelement 23 auf, die über zugeordnete Leitungen 24, 25 mit einem Ausgang 26 verbunden sind. Der Ausgang 26 des externen Schnittstellenelementes 2 ist über eine Datenleitung 27 mit einem Konfigurierungs- bzw. Diagnosegerät verbunden, das hier schematisch als PC 28 dargestellt ist. Zu diesem Zweck kann der Ausgang 26 eine Schnittstellenanpassung zum PC, beispielsweise für eine übliche serielle oder auch parallele Schnittstelle beinhalten.

Zwischen dem Lichtsendeelement 3 und dem Lichtempfangselement 22 sowie zwischen dem Lichtsendeelement 23 und dem Lichtempfangselement 4 erfolgt optoelektronisch ein Datenaustausch, was durch Pfeile 29, 30 dargestellt ist. Das externe Schnittstellenelement 2 weist ferner einen Magneten 31 auf, der z.B. ein Permanentmagnet sein kann. Durch "Ansetzen" bzw. "Anstecken" des externen Schnittstellenelementes 2 an die Schnittstellenkomponente 1 erfolgt eine Betätigung des Reed-Schalters 5 durch den Magneten 31. Das Feld des Magneten 31, welches den Reed-Schalter 5 erregt, ist schematisch durch einen Pfeil 32 dargestellt. Durch die "Aktivierung" des Reed-Schalters 5 werden die Controller 8, 9 über die Leitungen 10, 11 in eine vorgegebene Betriebsart, wie z.B. einen Konfigurierungs- bzw. Diagnosemodus geschaltet.

In dieser Betriebsart können von dem PC 28 Konfigurationsdaten oder Programme an die Controller 8 und/oder 9 gesandt werden. Umgekehrt können auch Daten aus den Controllern 8 und/oder 9 zum PC 28 ausgelesen werden. Eine Übertragung von Konfigurierungsdaten wird nur dann akzeptiert, wenn beide Controller 8, 9 intakt sind. Diagnosedaten hingegen können auch dann geliefert werden, wenn einer der Controller 8, 9 defekt ist.

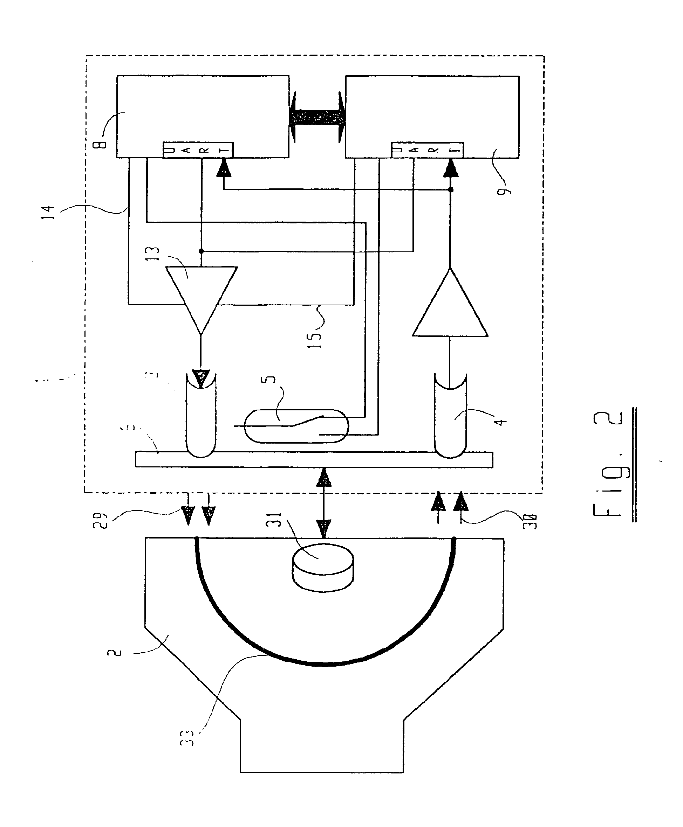

Fig. 2 zeigt ein weiteres Ausführungsbeispiel eines externen Schnittstellenelementes 2, das für die sog. "Teach-in"-Betriebsart vorgesehen ist.

Bei dieser Betriebsart wird beispielsweise die Verstärkung der nicht dargestellten Lichtempfangselemente der Lichtschranke automatisch eingestellt. Auch können bei Teilabdeckungen einzelner Strahlen Schwellwerte für den Lichtempfang eingestellt werden. Beim sog. "fixed blanking" werden aber in erster Linie die optisch unterbrochenen Lichtstrahlen nicht mehr bewertet und sind somit aus dem aktiven Schutzfeld ausgeklammert. Die Mikroprozessorsteuerung 7 erkennt diese Betriebsart dadurch, daß der Schalter 5 umgeschaltet ist und daß die dann von dem Lichtsendeelement 3 ausgesandten Daten in unveränderter Form am Lichtempfangselement 4 wieder empfangen werden.

Die erste Schnittstellenkomponente 1 ist identisch mit der der Fig. 1.

Das externe Schnittstellenelement 2 hingegen weist hier einen "durchgeschleiften" Lichtleiter 33 auf. Durch Ankoppeln der externen Schnittstelle 2 an die erste Schnittstellenkomponente 1 werden der Reed-Schalter 5 durch den Magnet 31 betätigt und die Controller 8, 9 in den Konfigurations- bzw. Diagnosemodus umgeschaltet. Das vom Lichtsendeelement 3 ausgesandte Licht wird über den Lichtleiter 33 dem Lichtempfangselement 4 zugeführt. Diese Betriebsart wird hier als "Teach-in"-Betriebsart bezeichnet. Statt dem Lichtleiter 33 kann auch eine Rückleitung durch eine optische Umlenkung mittels Prisma oder Spiegelanordnung ("Dachkantenspiegel" im 90° Winkel) verwendet werden.

Das externe Schnittstellenelement 2 ist hier also ein einfacher, manipulationssicherer, passiver, optomagnetischer "Schlüssel", der direkt auf die Frontscheibe bzw. Abdeckplatte 6 der Schnittstellenkomponente 1 aufgesetzt wird, um den von der Konfigurierungsschnittstelle, d.h. vom Controller 8 bzw. Verstärker 13 und dem Lichtsendeelement 3 erzeugten Datenstrom direkt auf den Empfangskanal der Konfigurierungsschnittstelle, d.h. zum Lichtempfangselement bzw. zum Controller 9 zu lenken. Diese Art eines "Tastendrucks" wird vom Empfänger akzeptiert, wenn:
a) der Sendedatenstrom 29 innerhalb eines sehr kleinen Zeitfensters auf dem Empfangskanal 30 erkannt wird und
b) der Reed-Schalter 5 durch den in den "Schlüssel" bzw. in das externe Schnittstellenelement 2 integrierten Dauermagneten 5 umgeschaltet wird.

Aufgrund der Menge von Konfigurierungsdaten des Empfängers ist es nicht möglich, diese ausschließlich mit Schaltern, z.B. mit DIP-Schaltern, auszuwählen. Deshalb erfolgt nur die Festlegung einzelner Hauptparameter per DIP-Schalter (nicht dargestellt). Zusätzlich können Konfigurierungsdaten, die in einem nicht flüchtigen EEPROM-Speicher abgelegt werden, per PC oder Teach-in konfiguriert werden.

Die Konfigurierungsschnittstelle dient zur bidirektionalen Übertragung von Konfigurierungs- und Diagnosedaten und ermöglicht den Anschluß eines Konfigurierungs- bzw. Diagnosegerätes, insbesondere eines PC (Fig. 1). Die Datenübertragung erfolgt auf optischem Wege durch die Frontscheibe 6 des Empfängers. Beide Controller 8, 9 werten die empfangenen Daten aus und führen einen Quervergleich durch. Zu sendende Daten werden nach einem Quervergleich nur von dem Controller 8 gesendet, wobei der Controller 8 die Nutzdaten und Controller 9 die Prüfsumme beisteuert. Zur zusätzlichen Sicherheit muß durch das externe Schnittstellenelement 2 auf magnetischem Wege der Reed-Kontakt 5 geschlossen werden, der von den Controllern 8, 9 ausgewertet wird.

Der Magnet 31 des externen Schnittstellenelementes 2 ist vorzugsweise ausreichend stark dimensioniert, so daß das Schnittstellenelement 2 samt Kabel 27 (Fig. 1) ausschließlich durch die erzeugten Magnetkräfte an der ersten Schnittstellenkomponente 1, d.h. an der in den Fig. 1 und 2 vertikal stehenden Abdeckplatte 6 gehalten wird. Durch den Magnet 31 wird das Schnittstellenelement 2 "automatisch" an der Abdeckplatte 6 positioniert, so daß die Lichtsendeelemente an den zugeordneten Lichtempfangselementen ausgerichtet sind und ein zuverlässiger Datenaustausch sichergestellt ist.

Die Abdeckplatte ist werksseitig so in ein nicht dargestelltes Gehäuse eingebaut, daß das Innere des Gehäuses nach außen hin vollständig abgedichtet ist. Damit läßt sich auch eine sehr hohe Schutzklasse, wie z.B. die Schutzklasse IP65, mühelos erreichen und zwar auch während der beiden oben beschriebenen Betriebsarten, bei denen die im Inneren des Gehäuses angeordneten Komponenten mit der Außenseite des Gehäuses in Datenaustausch stehen.

Durch das Aufsetzen eines externen Magneten mit oder ohne optischer Kommunikation oder direkter optischer Rückführung könnte ein integrierter Justage-Laser für eine bestimmte Zeitdauer eingeschaltet werden, um die mechanische Ausrichtung der Lichtschrankenanordnung zu unterstützen. Es kann vorgesehen sein, daß dies durch einen einfachen Magneten erfolgt, der also keine optische Rückführung wie in Fig. 2 und auch keine optische Kommunikation wie in Fig. 1 aufweist. Dadurch kann eine Hierarchie der Bedienung vorgegeben werden, beispielsweise daß Bedienpersonen der Maschinen nur einen Magneten haben und bei einer mechanischen Dejustage nur den Justage-Laser einschalten, während beispielsweise Maschineneinrichter schon den "Teach-in"-Betrieb durchführen dürfen und daher den Magneten mit der optischen Rückführung haben, während schließlich Systembetreuer auf die Schnittstelle der Fig. 1 mit Datenaustausch zu einem PC haben.

## Patentansprüche

1. Lichtschrankenanordnung mit einer Schnittstelle, **dadurch gekennzeichnet, dass** die Schnittstelle eine Schnittstellenkomponente (1) mit einer ersten optoelektronischen Kommunikationsrichtung (3, 4, 7) und einem magnetisch betätigbaren Schalter (5) aufweist, der zum Umschalten der ersten Kommunikationseinrichtung (3, 4, 7) in eine vorgegebene Betriebsart vorgesehen ist, und dass ein externes Schnittstellenelement (2) vorgesehen ist, das einen Magneten (31) zum Betätigen des Schalters (5) und eine der ersten Kommunikationseinrichtung (3, 4, 7) zugeordnete zweite optoelektronische Kommunikationseinrichtung (22, 23, 33) aufweist.

2. Lichtschrankenanordnung nach Anspruch 1, **dadurch gekennzeichnet, dass** die erste Kommunikationseinrichtung (3, 4, 7) ein erstes Lichtsendeelement (3) und ein erstes Lichtempfangselement (4) zum Senden beziehungsweise Empfangen von Konfigurierungs- und/oder Diagnosedaten aufweist.

3. Lichtschrankenanordnung nach einem der Ansprüche 1 oder 2, **dadurch gekennzeichnet, dass** die erste Kommunikationseinrichtung (3, 4, 7) eine Mikroprozessorsteuerung (7) aufweist, an die das erste Lichtsendeelement (3), das erste Lichtempfangselement (4) und der Schalter (5) angeschlossen sind.

4. Lichtschrankenanordnung nach Anspruch 3, **dadurch gekennzeichnet, dass** die Mikroprozessorsteuerung (7) zwei separate Controller (8, 9) aufweist, die dem ersten Lichtsendelement (3) beziehungsweise dem ersten Lichtempfangselement (4) zugeordnet sind.

5. Lichtschrankenanordnung nach Anspruch 4, **dadurch gekennzeichnet, dass** der Schalter (5) mit beiden Controllern (8, 9) über zugeordnete Steuerleitungen (10, 11) verbunden ist.

6. Lichtschrankenanordnung nach einem der Ansprüche 1 bis 5, **dadurch gekennzeichnet, dass** die zweite Kommunikationseinrichtung des externen Schnittstellenelements (2) ein dem ersten Lichtsendeelement (3) zugeordnetes Lichtempfangselement (22) und ein dem ersten Lichtempfangselement (4) zugeordnetes Lichtsendeelement (23) aufweist.

7. Lichtschrankenanordnung nach Anspruch 6, **dadurch gekennzeichnet, dass** das externe Schnittstellenelement (2) einen Anschluss (26) zur Verbindung des zweiten Lichtempfangselementes (22) und/oder des zweiten Lichtsendeelementes (23) mit einem Konfigurations-/Diagnoserechner (28) aufweist.

8. Lichtschrankenanordnung nach einem der Ansprüche 6 oder 7, **dadurch gekennzeichnet, dass** das zweite Lichtempfangselement (22) und das zweite Lichtsendeelement (23) über einen Lichtleiter (33) oder sonstige Lichtumlenkeinrichtungen, wie Prisma oder Spiegel, miteinander verbunden sind.

9. Lichtschrankenanordnung nach Anspruch 8, **dadurch gekennzeichnet, dass** das zweite Lichtempfangselement und das zweite Lichtsendeelement durch die beiden Enden des Lichtleiters (33) oder der Lichtumlenkeinrichtung gebildet sind.

10. Lichtschrankenanordnung nach einem der Ansprüche 1 bis 9, **dadurch gekennzeichnet, dass** der Schalter (5) ein Reed-Kontakt oder ein auf ein Magnetfeld ansprechender Schalter, wie z.B. eine Feldplatte, ein Hall-Generator oder elektronische magnetische Sensoren, wie integrierte Schaltungen, ist.

11. Lichtschrankenanordnung nach einem der Ansprüche 1 bis 10, **dadurch gekennzeichnet, dass** der Magnet (31) so dimensioniert ist, dass das externe Schnittstellenelement (2) allein durch Magnetkräfte an der Schnittstellenkomponente (1) fixierbar ist.

12. Lichtschrankenanordnung nach einem der Ansprüche 1 bis 11, **dadurch gekennzeichnet, dass** diese und/oder das externe Schnittstellenelement (2) so ausgebildet sind, dass das externe Schnittstellenelement (2) nur bei ordnungsgemäßer Ausrichtung der ersten und zweiten Lichtsendeelemente beziehungsweise der Lichtempfangselemente (3, 4, 22, 23) magnetisch an der Schnittstellenkomponente (1) fixierbar ist.

13. Lichtschrankenanordnung nach einem der Ansprüche 1 bis 12, **dadurch gekennzeichnet, dass** die Schnittstellenkomponente (1) beziehungsweise das externe Schnittstellenelement (2) so ausgebildet sind, dass sich das externe Schnittstellenelement (2) beim Ansetzen an die Schnittstellenkomponente (1) durch Magnetkräfte selbständig ausrichtet.

14. Lichtschrankenanordnung nach einem der Ansprüche 3 bis 13, **dadurch gekennzeichnet, dass** an die Mikroprozessorsteuerung (7) eine Vielzahl von Lichtsendeelementen beziehungsweise Lichtempfangselementen angeschlossen sind, die zur Überwachung eines Gefahrenbereichs vorgesehen sind.

15. Lichtschrankenanordnung nach einem der Ansprüche 1 bis 14, **dadurch gekennzeichnet, dass** durch den Magneten (31) zum Betätigen des Schalters (5) ein Justier-Laser für eine vorbestimmte Zeitdauer eingeschaltet wird.

## Claims

1. Light barrier arrangement with an interface, **characterised in that** the interface comprises an interface component (10) with a first optoelectronic communications device (3, 4, 7) and a magnetically actuable switch (5), which is provided for switching over the first communications device (3, 4, 7) to a predetermined operating mode, and that an external interface element (2) is provided, which comprises a magnet (31) for actuating the switch (5) and a second optoelectronic communications device (22, 23, 33) associated with the first communications device (3, 4, 7).

2. Light barrier arrangement according to claim 1, **characterised in that** the first communications device (3, 4, 7) comprises a first light transmitting element (3) and a first light receiving element (4) for transmitting and receiving, respectively, configuring and/or diagnostic data.

3. Light barrier arrangement according to one of claims 1 and 2, **characterised in that** the first communications device (3, 4, 7) comprises a microprocessor control (7) with which the first light transmitting element (3), the first light receiving element (4) and the switch (5) are connected.

4. Light barrier arrangement according to claim 3, **characterised in that** the microprocessor control (7) comprises two separate controllers (8, 9) which are associated with the first light transmitting element (3) and the first light receiving element (4), respectively.

5. Light barrier arrangement according to claim 4, **characterised in that** the switch (5) is connected with the two controllers (8, 9) by way of associated control lines (10, 11).

6. Light barrier arrangement according to any one of claims 1 to 5, **characterised in that** the second communications device of the external interface element (2) comprises a light receiving element (22) associated with the first light transmitting element (3) and a light transmitting element (23) associated with the first light receiving element (4).

7. Light barrier arrangement according to claim 6, **characterised in that** the external interface element (2) comprises a connection (26) for connecting the second light receiving element (22) and/or the second light transmitting element (23) with a configuration/diagnostic computer (28).

8. Light barrier arrangement according to one of claims 6 and 7, **characterised in that** the second light receiving element (22) and the second light transmitting element (23) are connected together by way of an optical conductor (33) or other optical deflecting devices, such as prisms or mirrors.

9. Light barrier arrangement according to claim 8, **characterised in that** the second light receiving element and the second light transmitting element are formed by the two ends of the optical conductor (33) or the optical deflecting device.

10. Light barrier arrangement according to any one of claims 1 to 9, **characterised in that** the switch (5) is a Reed contact or a switch, such as, for example, a field plate, a Hall generator or electronic-magnetic sensors, such as integrated switches, responding a magnetic field.

11. Light barrier arrangement according to any one of claims 1 to 10, **characterised in that** the magnet (31) is so dimensioned that the external interface element (2) is fixable to the interface component (1) solely by magnetic forces.

12. Light barrier arrangement according to any one of claims 1 to 11, **characterised in that** this and/or the external interface element (2) is so constructed that the external interface element (2) is magnetically fixable to the interface component (1) only in the case of correct alignment of the first and second light transmitting elements or light receiving elements (3, 4, 22, 23).

13. Light barrier arrangement according to any one of claims 1 to 12, **characterised in that** the interface component (1) or the external interface element (2) is so constructed that the external interface element (2) automatically self-aligns on attachment to the interface component (1) by magnetic forces.

14. Light barrier arrangement according to any one of claims 3 to 13, **characterised in that** a plurality of light transmitting elements or light receiving elements, which are provided for monitoring a risk area, is connected with the microprocessor control (7).

15. Light barrier arrangement according to any one of claims 1 to 14, **characterised in that** an adjusting laser is switched on for a predetermined time period by the magnets (31) for actuation of the switch (5).

## Revendications

1. Barrière optique pourvue d'une interface, **caractérisée en ce que** l'interface présente un composant d'interface (1) avec un premier dispositif de communication optoélectronique (3, 4, 7) et un commutateur (5) actionnable magnétiquement qui est prévu pour faire passer le premier dispositif de communication (3, 4, 7) dans un mode de fonctionnement prédéfini, et qu'il est prévu un élément d'interface externe (2) qui présente un aimant (31) servant à actionner le commutateur (5) et un deuxième dispositif de communication optoélectronique (22, 23, 33) associé au premier dispositif de communication (3, 4, 7).

2. Barrière optique selon la revendication 1, **caractérisée en ce que** le premier dispositif de communication (3, 4, 7) présente un premier élément émetteur de lumière (3) et un premier élément récepteur de lumière (4) pour respectivement envoyer et recevoir des données de configuration et/ou de diagnostic.

3. Barrière optique selon l'une des revendications 1 ou 2, **caractérisée en ce que** le premier dispositif de communication (3, 4, 7) présente une commande à microprocesseur (7) à laquelle le premier élément émetteur de lumière (3), le premier élément récepteur de lumière (4) et le commutateur (5) sont connectés.

4. Barrière optique selon la revendication 3, **caractérisée en ce que** la commande à microprocesseur (7) présente deux contrôleurs (8, 9) séparés qui sont respectivement associés au premier élément émetteur de lumière (3) et au premier élément récepteur de lumière (4).

5. Barrière optique selon la revendication 4, **caractérisée en ce que** le commutateur (5) est relié aux deux contrôleurs (8, 9) par l'intermédiaire de lignes de commande (10, 11) associées.

6. Barrière optique selon l'une des revendications 1 à 5, **caractérisée en ce que** le deuxième dispositif de communication de l'élément d'interface externe (2) présente un élément récepteur de lumière (22) associé au premier élément émetteur de lumière (3) et un élément émetteur de lumière (23) associé au premier élément récepteur de lumière (4).

7. Barrière optique selon la revendication 6, **caractérisée en ce que** l'élément d'interface externe (2) présente une connexion (26) pour relier le deuxième élément récepteur de lumière (22) et/ou le deuxième élément émetteur de lumière (23) à un calculateur de configuration/diagnostic (28).

8. Barrière optique selon l'une des revendications 6 ou 7, **caractérisée en ce que** le deuxième élément récepteur de lumière (22) et le deuxième élément émetteur de lumière (23) sont reliés ensemble par l'intermédiaire d'un guide de lumière (33) ou d'autres dispositifs déviateurs de lumière tels que prisme ou miroir.

9. Barrière optique selon la revendication 8, **caractérisée en ce que** le deuxième élément récepteur de lumière et le deuxième élément émetteur de lumière sont formés par les deux extrémités du guide de lumière (33) ou du dispositif déviateur de lumière.

10. Barrière optique selon l'une des revendications 1 à 9, **caractérisée en ce que** le commutateur (5) est un contact Reed ou un commutateur réagissant à un champ magnétique comme par exemple une magnétorésistance, un générateur de Hall ou des capteurs magnétiques électroniques comme des circuits intégrés.

11. Barrière optique selon l'une des revendications 1 à 10, **caractérisée en ce que** l'aimant (31) est dimensionné de façon que l'élément d'interface externe (2) puisse être fixé au composant d'interface (1) uniquement par des forces magnétiques.

12. Barrière optique selon l'une des revendications 1 à 11, **caractérisée en ce que** celle-ci ou l'élément d'interface externe (2) sont conçus de façon que l'élément d'interface externe (2) ne puisse être fixé magnétiquement au composant d'interface (1) qu'en cas d'alignement correct des premier et deuxième éléments émetteurs de lumière, respectivement des éléments récepteurs de lumière (3, 4, 22, 23).

13. Barrière optique selon l'une des revendications 1 à 12, **caractérisée en ce que** le composant d'interface (1), respectivement l'élément d'interface externe (2) sont conçus de façon que l'élément d'interface externe (2) s'aligne de lui-même sous l'effet de forces magnétiques lors de son application sur le composant d'interface (1).

14. Barrière optique selon l'une des revendications 3 à 13, **caractérisée en ce que** plusieurs éléments émetteurs de lumière, respectivement éléments récepteurs de lumière, qui sont prévus pour surveiller une zone de danger sont connectés à la commande à microprocesseur (7).

15. Barrière optique selon l'une des revendications 1 à 14, **caractérisée en ce qu'**un laser d'ajustage est activé pendant une durée prédéterminée par l'aimant (31) servant à actionner le commutateur (5).
